Europäisches Patentamt

European Patent Office

Office européen des brevets

(11) Numéro de publication: **0 300 524 B1**

# FASCICULE DE BREVET EUROPEEN

(45) Date de publication de fascicule du brevet: **08.09.93** (51) Int. Cl.5: **H03H 7/25**

(21) Numéro de dépôt: **88201248.7**

(22) Date de dépôt: **17.06.88**

(54) **Dispositif d'atténuation variable destiné à être inséré entre un circuit émetteur et un circuit de charge.**

(30) Priorité: **30.06.87 FR 8709208**

(43) Date de publication de la demande:
**25.01.89 Bulletin 89/04**

(45) Mention de la délivrance du brevet:
**08.09.93 Bulletin 93/36**

(84) Etats contractants désignés:
**DE FR GB IT SE**

(56) Documents cités:
**DE-A- 2 912 434**
**US-A- 4 378 536**
**US-A- 4 621 244**

**ELECTRONIC DESIGN, vol. 25, no. 7, 29 mars 1977, pages 100-102, Rochelle Park, US; R.S. VILES: "Need a PIN-diode attenuator"**

(73) Titulaire: **TELECOMMUNICATIONS RADIOE-LECTRIOUES ET TELEPHONIOUES T.R.T.**
**88, rue Brillat Savarin**
**F-75013 Paris(FR)**

(84) Etats contractants désignés:
**FR**

(73) Titulaire: **N.V. Philips' Gloeilampenfabrieken**

**Groenewoudseweg 1**
**NL-5621 BA Eindhoven(NL)**

(84) Etats contractants désignés:
**DE GB IT SE**

(72) Inventeur: **Petitjean, Gilbert**
**SOCIETE CIVILE S.P.I.D. 209 rue de l'Université**
**F-75007 Paris(FR)**
Inventeur: **Lebourg, Michel**
**SOCIETE CIVILE S.P.I.D. 209 rue de l'Université**
**F-75007 Paris(FR)**
Inventeur: **Le Tortorec, Christian**
**SOCIETE CIVILE S.P.I.D. 209 rue de l'Université**
**F-75007 Paris(FR)**

(74) Mandataire: **Chaffraix, Jean et al**
**Société Civile S.P.I.D. 156, Boulevard Haussmann**
**F-75008 Paris (FR)**

EP 0 300 524 B1

EP 0 300 524 B1

## Description

La présente invention concerne un dispositif d'atténuation variable destiné à être inséré entre un circuit émetteur présentant une certaine impédance interne et un circuit de charge, dispositif formé d'au moins une branche d'atténuation parallèle constituée à partir d'un élément à résistance variable (diode P.I.N. notamment) et d'un circuit de polarisation pour faire varier la résistance de l'élément en fonction d'une grandeur de commande d'atténuation, la branche d'atténuation parallèle comportant un élément dissipatif qui est placé en série avec l'élément a' résistance variable et dont la valeur assure l'adaptation de l'impédance interne du circuit émetteur.

De tels dispositifs sont bien connus et trouvent d'importantes applications notamment comme modulateur d'amplitude d'un émetteur radio, la modulation agissant comme grandeur de commande d'atténuation. On s'efforce dans ce genre d'application, afin d'obtenir une bonne dynamique de modulation, de pouvoir supporter des puissances relativement élevées du circuit émetteur.

Les dispositifs d'atténuation connus, par exemple celui décrit dans le brevet DE 29 12 434 ne conviennent pas pour présenter une bonne adaptation dans une large gamme de fréquences.

La présente invention a pour but de fournir un dispositif d'atténuation capable de supporter une puissance élevée et qui reste adapté sur une large gamme de fréquences.

Pour cela, un tel dispositif est remarquable en ce que pour atténuer des ondes de 100 à 400 MHz environ, l'élément à résistance variable est une diode P.I.N. présentant une durée de vie de porteurs minoritaires comprise entre 3 et 5 $\mu$s et une pente de la caractéristique Rs/If présentant une valeur entre 35 et 80 $\Omega$ pour un courant If = 1 mA et une valeur supérieure à 350 $\Omega$ pour If = 100 $\mu$A.

Dans l'application envisagée, pour obtenir de bonnes performances en tant que modulateur, la demanderesse s'est rendue compte que le choix de diodes P.I.N. est capital. Selon une caractéristique importante de l'invention, les éléments à résistances variables sont des diodes P.I.N. présentant des durées de vie de porteurs minoritaires comprises entre 3 et 5 $\mu$s et une pente de la caractéristique Rs/If présentant une valeur entre 35 et 80 $\Omega$ pour un courant If = 1 mA et une valeur supérieure à 350 $\Omega$ pour If = 300 $\mu$A.

Rs représente la valeur de la résistance
et If le courant traversant la diode P.I.N.

La description suivante, accompagnée des dessins annexés, le tout donné à titre d'exemple non limitatif fera bien comprendre comment l'invention peut être réalisée.

La figure 1 représente le schéma de principe du dispositif d'atténuation de l'art antérieur.

La figure 2 représente le schéma du mode de réalisation du dispositif d'atténuation conforme à l'invention.

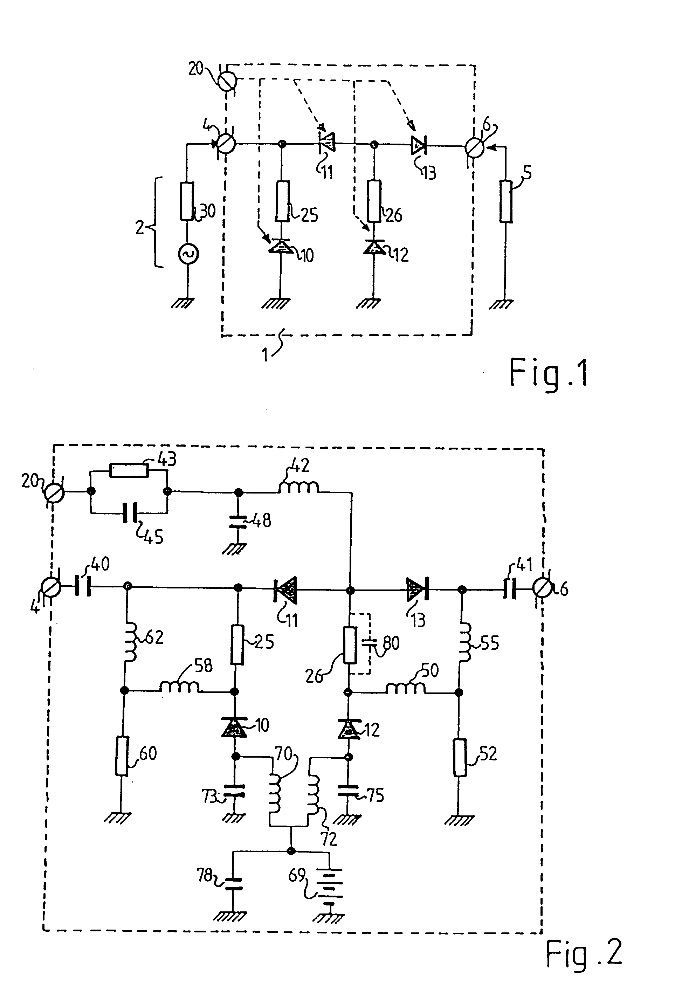

A la figure 1, la reférence 1 indique le dispositif d'atténuation à insérer entre un circuit émetteur 2 qui vient se connecter entre la borne d'entrée 4 et la terre et un circuit de charge 5 qui se connecte entre la borne de sortie 6 et la terre. Le dispositif est constitué à partir de diodes P.I.N. 10, 11, 12 et 13 placées soit en parallèle (diodes 10 et 12), soit en série (diodes 11 et 13). Pour faire varier la conduction de ces diodes, on a prévu un circuit de polarisation, montré simplement en pointillé à cette figure 1, qui permet de polariser les diodes PIN de façon convenable à partir d'une tension de commande appliquée à la borne de commande 20.

Conformément à l'art antérieur, on a disposé des éléments résistifs 25 et 26 en série avec les diodes 10 et 12 et la valeur de la résistance de ces éléments est telle qu'elle assure tant l'adaptation de la résistance interne du circuit émetteur 2, représentée par la référence 30, que celle du circuit de charge 5.

La figure 2 montre le schéma de réalisation du dispositif et détaille bien le circuit de polarisation des diodes 10, 11, 12, 13. Les références représentant les éléments déjà décrits à la figure 1 restent inchangées. De façon à pouvoir isoler du point de vue courant continu le dispositif des circuits émetteurs et du circuit de charge, on a disposé un premier condensateur d'isolement 40 entre la borne 4 et la cathode de la diode 11 et un deuxième condensateur d'isolement 41 entre la borne 6 et la cathode de la diode 13. Les anodes des diodes 11 et 13 sont reliées à la borne 20 par l'intermédiaire d'une self de blocage 42 et un circuit RC formé d'une résistance 43 et d'un condensateur 45 en parallèle. Un condensateur 48 réunit à la masse le point commun de la self 42 et du circuit RC. Les anodes des diodes 11 et 13 sont réunies à la masse pour le courant continu par l'intermédiaire de l'élément 26, par une self 50 et une résistance 52. La cathode de la diode 13 est reliée à la masse par l'intermédiaire d'une self 55 et de la résistance précitée 52. La cathode de la diode 11 est reliée à la terre toujours en ce qui concerne le courant continu par l'intermédiaire d'un premier circuit formé de l'élément 25, d'une self 58 et d'une résistance 60 et d'un deuxième circuit formé d'une self 62 et la résistance précitée 60.

Les anodes des diodes 10 et 12 reçoivent une tension continue provenant d'un générateur de tension 69 et par l'intermédiaire de selfs 70 et 72 respectivement. Des condensateurs 73 et 75 branchés entre les

2

anodes des diodes 10 et 12 assurent un chemin vers la terre pour les courants à haute fréquence. On peut aussi prévoir le branchement d'un condensateur 78 en parallèle sur le générateur 69. En outre, la demanderesse s'est aperçu qu'en connectant un condensateur 80 de capacité relativement faible aux bornes de l'élément 26, on améliore l'adaptation du dispositif.

Le générateur 69 fournit, en l'absence de tension de commande à la borne 20, une tension telle que les diodes 10 et 12 sont à l'état passant et les diodes 11 et 13 à l'état bloqué ; l'atténuation est alors maximum, le circuit émetteur 2 est bouclé par l'élément 25 dont la valeur correspond à sa résistance interne.

Lorsque à la borne 20 la tension croît, les diodes 11 et 13 commencent à conduire et les diodes 10 et 12 sont moins passantes. Lorsque les diodes 11 et 13 sont totalement passantes et les diodes 10 et 12 complètement bloquées, l'atténuation est minimale.

La demanderesse a trouvé que les valeurs des éléments données au Tableau ci-dessous procurent de meilleurs résultats dans la gamme de fréquences allant de 100 MHz à 400 MHz.

## TABLEAU

| Valeur des résistances | en ohms |
|---|---|
| 25 | |
| 26 | |
| 43 | 50 |
| 52 | |
| 60 | |

| Valeur des selfs inductances | en µH |
|---|---|
| 42 | |
| 50 | |
| 55 | |
| 58 | 1 |
| 62 | |
| 70 | |
| 72 | |

| Valeur des condensateurs | |
|---|---|
| 40 | 470 pF |
| 41 | 470 pF |
| 45 | 0,1 µF |
| 48 | |
| 73 | |
| 75 | 470 pF |
| 78 | |

Hormis ces paramètres d'atténuation et de dissipation, les caractéristiques des diodes PIN ont un rôle capital, notamment en ce qui concerne la distorsion de modulation et la réjection harmonique. Dans ces conditions particulières d'utilisation, deux paramètres sont prépondérants :

a) la durée de vie des porteurs minoritaires : celle-ci doit être comprise entre 3 et 5 $\mu$s.

b) la pente de la caractéristique Rs/If. Elle peut être définie par la valeur de la résistance "série" en deux points de la caractéristique : celle-ci doit être comprise entre 35 $\Omega$ et 80 $\Omega$ pour $I_F$ = 1 mA, et supérieure à 350 Ω pour I$_F$ = 100 $\mu$A.

Les diodes (spéciales) :

DH 493-19 fabriquée par THOMSON-CSF en FRANCE

et DSB6479-42 fabriquée par ALPHA INDUSTRIES aux ETATS-UNIS

conviennent pour le dispositif conforme à l'invention.

Avec de telles valeurs et circuits émetteurs présentant une résistance interne de 50 Ω égale à celle du circuit de charge, le R.O.S. (rapport d'onde stationnaire) reste inférieur à 1,6 pour une atténuation variant de moins de 2 dB à plus de 50 dB -la puissance à l'entrée étant de plusieurs watts- les fréquences de modulation allant de 0 à 25 kHz avec une tension à la borne 20 allant de 0 à 10 Volts.

Il doit être signalé que l'atténuation n'est pas une fonction linéaire de la tension appliquée à la borne de commande 20 et il appartient à l'utilisateur de prévoir, avant la borne 20, tout circuit non linéaire qui lui procurera la caractéristique d'atténuation désirée.

**Revendications**

1. Dispositif d'atténuation variable destiné à être inséré entre un circuit émetteur présentant une certaine impédance interne et un circuit de charge, dispositif formé d'au moins une branche d'atténuation parallèle constituée à partir d'un élément à résistance variable (diode P.I.N. notamment) et d'un circuit de polarisation pour faire varier la résistance de l'élément en fonction d'une grandeur de commande d'atténuation, la branche d'atténuation parallèle comportant un élément dissipatif qui est placé en série avec l'élément à résistance variable et dont la valeur assure l'adaptation de l'impédance interne du circuit émetteur, caractérisé en ce que pour atténuer des ondes de 100 à 400 MHz environ, l'élément à résistance variable est une diode P.I.N. présentant une durée de vie de porteurs minoritaires comprise entre 3 et 5 $\mu$s et une pente de la caractéristique Rs/If présentant une valeur entre 35 et 80 Ω pour un courant If = 1 mA et une valeur supérieure à 350 Ω pour If = 100 $\mu$A.

2. Dispositif d'atténuation selon la revendication 1, caractérisé en ce qu'il comporte au moins une branche d'atténuation série entre le circuit émetteur et le circuit de charge.

**Claims**

1. Variable attenuation device intended to be inserted between a transmitter circuit having a certain internal impedance and a load circuit, this device comprising at least one parallel attenuation branch made up from a variable resistor element (PIN diode) and a bias circuit for varying the resistance of the element as a function of an attenuation control variable, the parallel attenuation branch comprising a dissipating element connected in series with the variable resistor element and whose value ensures the adaptation of the internal impedance of the transmission circuit, characterized in that the variable resistor element for attenuating waves of about 100 to 400 MHz is a PIN diode which has a minority carrier lifetime of about 3 to 5 microseconds and a slope of the characteristic Rs/If having a value between 35 and 80 ohms for a current If = 1 milliampere and a value exceeding 350 ohms for If = 100 microamperes.

2. Attenuation device as claimed in claim 1, characterized in that it comprises at least one series attenuation branch inserted between the transmitter circuit and the load circuit.

**Patentansprüche**

1. Regelbares Dämpfungsglied zum Einfügen zwischen einem Sendekreis mit einer bestimmten inneren Impedanz und einem Belastungskreis, wobei dieses Glied mindestens einen Parallel-Dämpfungszweig aufweist, der aus einem Element mit veränderlichem Widerstand (insbesondere einer PIN-Diode) und einem Vorspannkreis besteht zum Variieren des Widerstandes des Elementes als Funktion einer Dämpfungssteuergröße, wobei dieser Parallel-Dämpfungszweig ein Verbrauchselement enthält, das mit dem Element veränderlichen Widerstandes in Reihe geschaltet ist, und dessen Wert die Anpassung der inneren Impedanz des Sendekreises gewährleistet, dadurch gekennzeichnet, daß zum Dämpfen von Wellen von etwa 100 bis 400 MHz das veränderliche Widerstandelement eine PIN-Diode ist mit einer Lebensdauer der Minoritätsträger von etwa 3 bis 5 $\mu$s und wobei die Neigung der Kennlinie Rs/If einen Wert hat zwischen 35 und 80 Ohm für einen Strom If = 1 mA und einen Wert über 350 Ohm für If = 100 $\mu$A.

2. Dämpfungsglied nach Anspruch 1, dadurch gekennzeichnet, daß es mindestens einen Reihendämpfungszweig zwischen dem Sendekreis und dem Belastungskreis aufweist.

Fig.1

Fig.2